# EUROPEAN PATENT SPECIFICATION

(11) **EP 2 748 853 B1**
(45) Date of publication and mention of the grant of the patent: **11.10.2023**
(21) Application number: 12768695.4
(22) Date of filing: 24.08.2012
(51) Int. Cl.: H01L 27/146, B23K 26/361

(54) **WAFER-LEVEL FABRICATION OF OPTICAL DEVICES. IN PARTICULAR OF MODULES FOR COMPUTATIONAL CAMERAS**
HERSTELLUNG OPTISCHER VORRICHTUNGEN AUF WAFEREBENE, INSBESONDERE VON MODULEN FÜR BERECHNUNGSKAMERAS
FABRICATION SUR TRANCHE DE DISPOSITIFS OPTIQUES, EN PARTICULIER DE MODULES DESTINÉS À DES CAMÉRAS INFORMATIQUES

(30) Priority: 25.08.2011 US 201161527355 P
(43) Date of publication of application: 02.07.2014
(73) Proprietor: Heptagon Micro Optics Pte. Ltd., Singapore 738317 (SG)
(72) Inventor: RUDMANN, Hartmut, 8645 Jona (CH); MALUCK, Matthias, 6300 Zug (CH); BIETSCH, Alexander, 8800 Thalwil (CH); ROENTGEN, Peter, 8800 Thalwil (CH); HEIMGARTNER, Stephan, 5032 Aarau Rohr (CH)
(74) Representative: Marks & Clerk LLP
(86) International application number: PCT/CH2012/000200
(87) International publication number: WO 2013/026174

(56) References cited:
- WO-A1-2009/102602
- WO-A1-2011/049635
- WO-A2-2011/063347
- US-A1- 2004 165 823
- US-A1- 2006 044 450
- US-A1- 2008 230 934

## Description

### Technical Field

The invention relates to the field of optics, more particularly micro-optics. In particular, it relates to wafer-level fabrication of optical devices such as optical systems, opto-electronic modules and cameras.

### Background of the Invention

From the international patent application published as WO 2011/156928 A2 (filed on June 10, 2011), cameras and optical modules for cameras are known, which can be fabricated on wafer level. Therein, cameras and optical modules for cameras as well as methods for manufacturing the same are disclosed in some detail.

From US 2004/165823 a method for manufacturing an optical device, according to the preamble of claim 1, is known.

### Definition of Terms

"Active optical component": A light sensing or a light emitting component. E.g., a photodiode, an image sensor, an LED, an OLED, a laser chip.

"Passive optical component": An optical component redirecting light by refraction and/or diffraction and/or reflection such as a lens, a prism, a mirror, or an optical system, wherein an optical system is a collection of such optical components possibly also comprising mechanical elements such as aperture stops, image screens, holders.

"Opto-electronic module": A component in which at least one active and at least one passive optical component is comprised.

"Replication": A technique by means of which a given structure or a negative thereof is reproduced. E.g., etching, embossing, imprinting, casting, molding.

"Wafer": A substantially disk- or plate-like shaped item, its extension in one direction (z-direction or vertical direction) is small with respect to its extension in the other two directions (x- and y-directions or lateral directions). Usually, on a (non-blank) wafer, a plurality of like structures or items are arranged or provided therein, typically on a rectangular grid. A wafer may have opening or holes, and a wafer may even be free of material in a predominant portion of its lateral area. Although in many contexts, a wafer is understood to be prevailingly made of a semiconductor material, in the present patent application, this is explicitely not a limitation. Accordingly, a wafer may prevailingly be made of, e.g., a semiconductor material, a polymer material, a composite material comprising metals and polymers or polymers and glass materials. In particular, hardenable materials such as thermally or UV-curable polymers are interesting wafer materials in conjunction with the presented invention.
"Lateral": cf. "Wafer"
"Vertical": cf. "Wafer"
"Light": Most generally electromagnetic radiation; more particularly electromagnetic radiation of the infrared, visible or ultraviolet portion of the electromagnetic spectrum.

### Summary of the Invention

The invention is defined in claim 1. Embodiments of the invention are set out in the dependent claims.

### Brief Description of the Drawings

Below, the invention is described in more detail by means of examples and the included drawings. The figures show in a strongly schematized manner:
- Fig. 1: an exploded view of a device, in a cross-sectional view;
- Fig. 2: an illustration that from a number of sub-images, a full image can be obtained;
- Fig. 3: a spacer member with lens shapes, in a cross-sectional view;
- Fig. 4: a spacer member with lens shapes, in a cross-sectional view;
- Fig. 5: a spacer member with non-transparently surrounded light channels, in a cross-sectional view;
- Fig. 6: a spacer member with not-separated light channels, in a cross-sectional view;
- Fig. 7: a spacer member, in a cross-sectional view;
- Fig. 8: a spacer member, in a cross-sectional view;
- Fig. 9: a spacer member, in a cross-sectional view;
- Fig. 10: a detail of a wafer stack comprising spacer members comprising more than one unitary parts, in a cross-sectional view;
- Fig. 11: a detail of the wafer stack of Fig. 10 after a first processing step, in a cross-sectional view;
- Fig. 12: a detail of the wafer stack of Figs. 10 and 11 after a second processing step, in a cross-sectional view;
- Fig. 13: a detail of a wafer stack comprising a two-times processed spacer member comprising more than one unitary parts, in a cross-sectional view;
- Fig. 14: a member of non-transparent material comprising through-holes as light channels, in a cross-sectional view;
- Fig. 15: the member of Fig. 14, with transparent material filled in the light channels, in a cross-sectional view;
- Fig. 16: the member of Fig. 14, with dfferent amounts of transparent material filled in the light channels, in a cross-sectional view.

The described embodiments are meant as examples.

### Detailed Description of the Invention

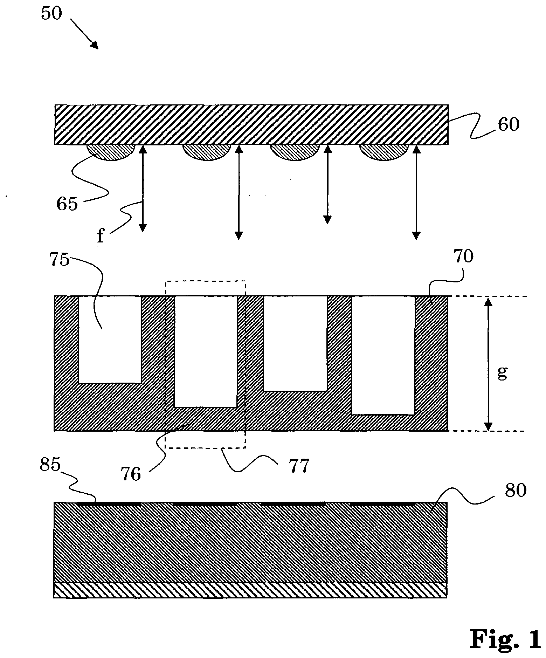

Fig. 1 is a schematic illustration of an aspect of the invention, in a cross-sectional view. It shows, in an exploded view, three members, namely an optics member 60, a spacer member 70 and a detection member 80, which form together a device 50, more particularly an opto-electronic module 50.

Optics member 60 comprises several passive optical components 65, in particular lenses 65. Passive optical components 65 have assigned nominal focal lengths, in particular all have the same nominal focal length. But - usually for manufacturing reasons - the focal lengths of the passive optical components 65 (more particularly: front focal lengths) deviate from their respective nominal focal length, as shown in Fig. 1 by the arrows referenced f.

Detection member 80 can in particular be a semiconductor chip comprising active optical components 85 such as image sensors 85.

Spacer member 70 contributes to ensuring a pre-defined distance cf. reference "g" in Fig. 1) between member 60 and member 80. But, moreover, it also contributes to an at least partial correction of the above-described deviations from the nominal focal lengths. Spacer member 70 comprises several light channels 77, one per each passive optical component 65. Each of the light channels 77 comprises a blind hole 75 and a portion of transparent material 76.

The index of refraction of the material of spacer member 70 is different from (usually greater than) the index of refraction of vacuum or air which is usually present in the blind holes 75. Thus, by adjusting the lengths of the blind holes 75 in dependence of the deviations of the focal length of the associated passive optical component 65 from the respective nominal focal lengths, deviations can be compensated, at least to some degree. The geometrical length g is (at least nominally) identical for each of the light channels 77; it corresponds to a (maximum or overall) vertical extension of spacer member 70.

Therefore, the lengths of the blind holes are different for differently deviating passive optical components 65.

This way, it can be achieved that an imaging taking place using the different passive optical components 65 with their different focal lengths results in the (nominally) desired imaging. And thus, each active optical component 85 of member 80, e.g., detecting elements 85 such as image sensors 85, can record the desired image; without the individually chosen or adjusted blind holes, the recorded images would deviate or differ from the desired images, usually to an extent depending on the amount of manufacturing irregularities of the respective passive optical components 65. In particular, each active optical component 85 records one sub-image, e.g., one plenoptic camera sub-image or one array camera sub-image, or one sub-image for one color or wavelength range, wherein in that case not all active optical components 85 record sub-images for the same color or wavelength range.

The sub-images taken by the different active optical components 85 can be processed so as to derive from them a full (final) image.

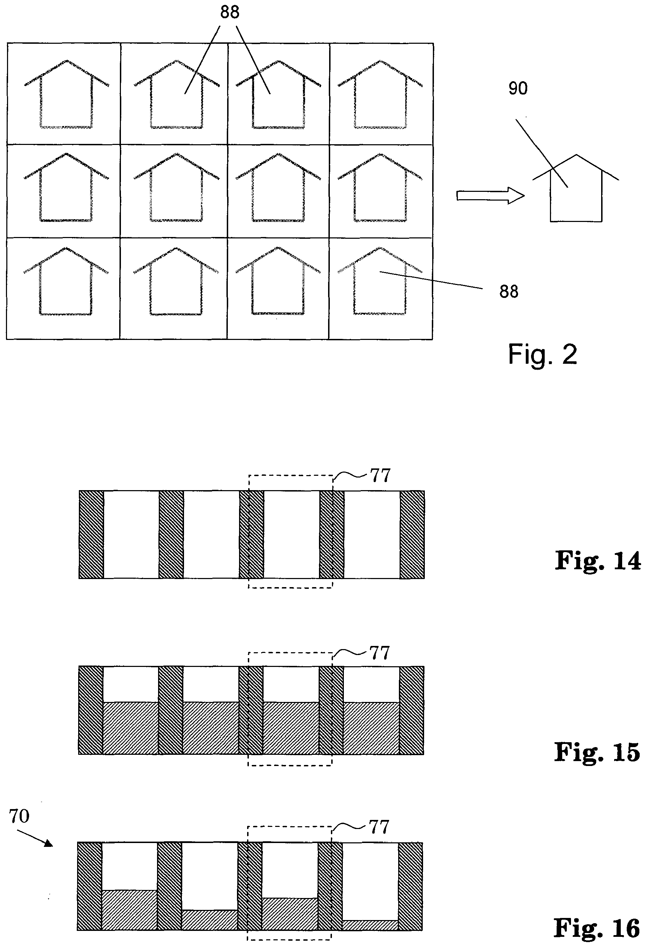

Fig. 2 illustrates that from a number of such sub-images 88, a full image 90 can be obtained.

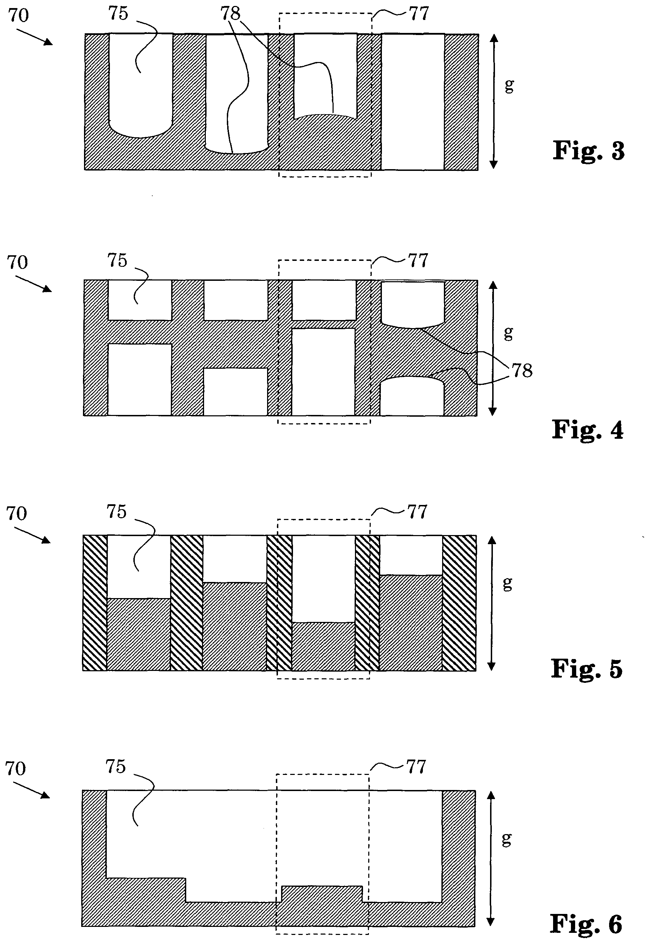

There are also other possibilities to achieve a variation in optical path length between the different light channels 77 despite of them having the same geometrical path length g, see, e.g., the patent claims. E.g., shapes such as lens-shapes can be produced in the optical paths, e.g., in the blind holes. Figs. 3 and 4 show, in a cross-sectional view, a spacer member 70 with blind holes having a curved (lens-shaped) bottom 78. In other words, lens elements are formed in the light channels. In Fig. 3, it is also illustrated that, according to a non claimed example but useful for understanding the invention, a light channel may comprise a through-hole (cf. the right-most channel in Fig. 3). In Fig. 4, it is also illustrated that material can be removed from both sides of the spacer member 70, i.e. from the object side (generally in all the Figures showing a spacer member meant to be towards the top of the drawing page, like in Fig. 1) at which an optics member will usually be located, and at the detector side (generally in all the Figures showing a spacer member meant to be towards the bottow of the drawing page, like in Fig. 1), at which an detection member will usually be located. Generally, spacer members illustrated in one of the Figures of the present patent application may be used as a spacer member in devices like the one illustrated in Fig. 1, replacing the spacer member shown there.

The light channels 77 may be separate from each other, in particular optically separate from each other. E.g., a portion of the spacer member may be made of a non-transparent material, in particular such that each light channel 77 is at least partially sourrounded by non-transparent material. Fig. 5 illustrates a spacer member 70 with non-transparently surrounded light channels 77, in a cross-sectional view, according to a non claimed example. The outer portion of each light channel 77 is made of a non-transparent material, e.g, of a hardened hardenable material such as a curable epoxy resin, whereas the inner portion is filled with a transparent material such as, again, a hardened hardenable material such as a curable epoxy resin, wherein said filling fills the respective light channel (i.e. in the illustrated case, the respective through-hole in spacer member 70) laterally completely, but (generally for at least one of the light channels) vertically only in part. A lateral cross-section through a light channel can be, e.g., circular or rectangular (with sharp or with rounded corners).

But it is also possible to provide that at least one of the light channels 77 is adjacent to at least one other light channels of the spacer member or is even partially overlapping with at least one other light channels of the spacer member. Fig. 6 illustrates a spacer member 70 with not-separated light channels, in a cross-sectional view.

A possible advantage of optically separated light channels, cf., e.g., Fig. 5, is the possibility to suppress cross-talk between the light channels. A possible advantage of not-separated light channels is that a corresponding device can be (laterally) smaller, passive optical components (cf. Fig. 1) can be closer to each other, and detection members (cf. Fig. 1) can be closer to each other.

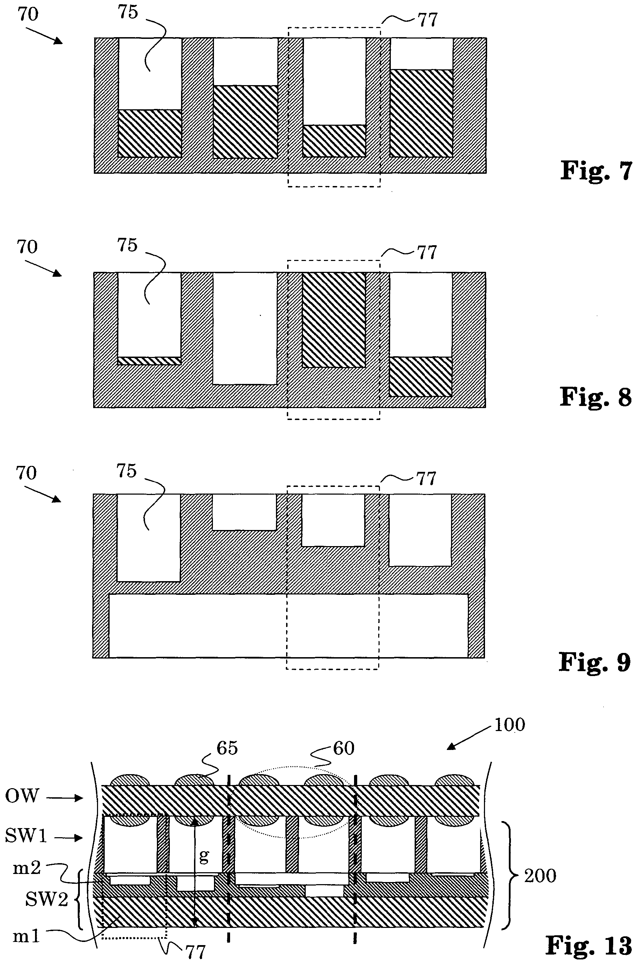

Fig. 7 illustrates another spacer member 70, in a cross-sectional view. This is to illustrate that one can also fill liquid material into a blind-hole. Also this filled-in material may be hardened. The amount of filled-in material can be selected such that a sought compensation of manufacturing irregularities is achieved.

Fig. 8 illustrates another spacer member 70, in a cross-sectional view. This is to illustrate that one can prepare, e.g., by means of replication, a wafer (or member) already implementing a compensation for manufacturing irregularities of an optics member. And furthermore, it illustrates that it is possible, in addition, to then fill liquid material into the blind-holes for fine-tuning the compensation.

Fig. 9 illustrates another spacer member 70, in a cross-sectional view. This is to illustrate on the one hand that it is possible to carry out corrections / adjustments that (simultaneously) apply to all channels of a spacer member 70, and on the other hand that the detector side of a spacer member 70 does not necessarily have to describe a single plane (cf. also Fig. 4). But, it can be advantageous to provide that the detector side of a spacer member 70 describes a single plane (as is illustrated in most Figures of the present patent application), because in that case, the spacer member can be readily bonded to a detection member (cf. Fig. 1) without providing additional interfaces (between air and a higher refractive index material such as material of the spacer member or of the detection member), which again can result in less reflection losses and in a higher imaging quality.

The general function of a device 50 (cf. Fig. 1) is that light impinging from an object side (above member 60 in Fig. 1) is imaged by passive optical components 65 through light channels 77 onto the active optical components 85 of member 80.

Devices 50 can be used, e.g., in a communication device and/or in a camera such as in an array camera.

It is suggested to manufacture any of, in particular all of the members 60, 70, 80 in form of wafers each comprising a multitude of the respective members. This can make the manufacture of the device 50 very efficient, including simplifying accomplishing the individual adjustments suggested for the compensating for of the manufacturing irregularities.

E.g., the focal length of each of the passive optical components 65 is determined, and, in dependence of the result thereof, the blind holes are created (e.g., by drilling and/or laser ablation) having the appropriate length (cf., e.g., Figs. 1, 3, 4, 6, 9, which can be interpreted accordingly); or a suitable spacer wafer is produced using replication already taking into account - by using a suitable replication master - the manufacturing irregularities to be compensated for (cf., e.g., Figs. 1, 3, 6, 9, which can be interpreted accordingly).

According to the invention, these two approaches are combined by using a suitable spacer wafer already compensating to some extent for the manufacturing irregularities, by having blind holes of corresponding lengths, and then to apply further corrections, such as by changing the optical path length through light channels by means of which a sufficient compensation of the respective manufacturing irregularities has not yet been achieved (cf., e.g., Figs. 3, 4, 8, 9, which can be interpreted accordingly). These further corrections are accomplished, by drilling and/or machining and/or cutting and/or laser ablation.

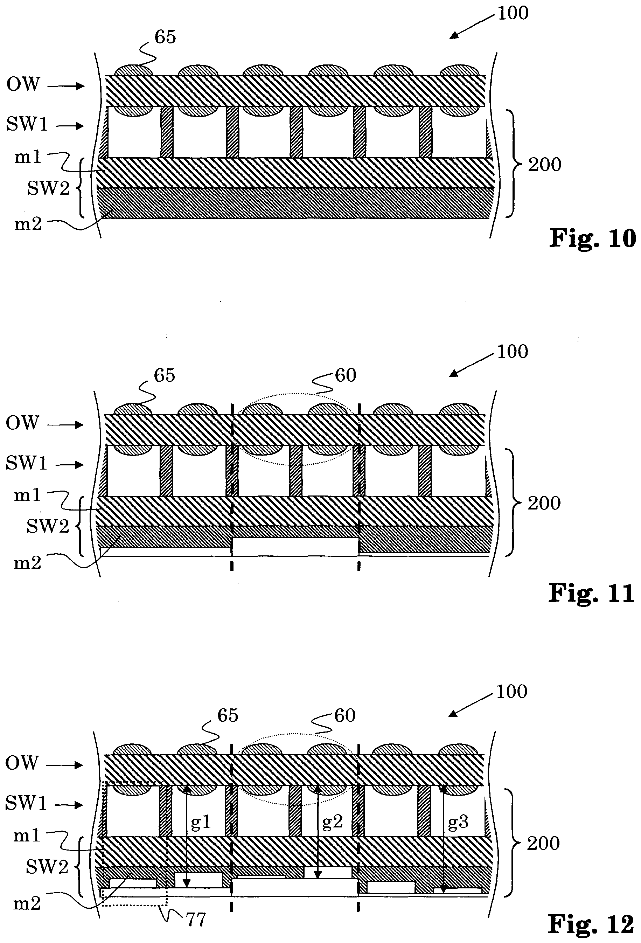

Figs. 10 to 12 illustrate further possible aspects and non claimed embodiments.

Figs. 10 to 12 illustrate, in a cross-sectional view, a wafer stack 100 comprising an optics wafer OW comprising passive optical components 65 at least a portion of which have manufacturing irregularities such as focal lengths deviating from a nominal value, and, attached thereto, a spacer wafer stack 200. Optics wafer OW comprises a multitude of optics members 60, and spacer wafer stack 200 comprises a multitude of spacer members, wherein in wafer stack 100, each optics member is associated and aligned with a different one of the spacer members. Detection members and a detection wafer are not illustrated in Figs. 10 to 12.

Spacer wafer stack 200 comprises a spacer wafer SW1 and a spacer wafer SW2. Spacer wafer SW1 is made of a non-transparent material and can thus strongly contribute to optically mutally isolating light channels 77. Spacer wafer SW1 can furthermore be provided for ensuring a desired (vertical) distance between optics wafer OW and spacer wafer SW2. One particularity of wafer stack 200 is that spacer wafer SW2 comprises two layers ml, m2 of different (but transparent) materials. E.g., layer ml is made of glass, and layer m2 is made of a polymer material, or layer ml is made of a polymer material, and layer m2 is made of glass. It can, more generally, be provided that the layer (ml) facing optics wafer OW is provided for providing mechanical stability, whereas the other layer (m2) (more particular, the material of which it is made) is mechanically less stable than (the material of) layer ml. And/or, it can be provided that, considering a method or process for removing material from spacer wafer SW2, the material of layer m2 is easier to remove than the material of layer ml. It is to be noted, however, that layer ml can, in general, also be dispensed with.

It is furthermore generally possible to consider layers ml and m2, respectively, as distinct spacer wafers which, however, are bonded to each other.

More specifically, as illustrated in Figs. 11 and 12, it is possible to provide that a removal of material for compensating for manufacturing irregularities of optics wafer OW takes place in layer m2 only.

Furthermore, Figs. 10 to 12, and more specifically, Figs. 11 and 12, illustrate that it is possible to carry out a removal of material from a spacer wafer or from a spacer wafer stack 200 (or, more specifically from a layer m2) in two (or generally: two or more) processing steps. Removing material can allow to change the optical path length in light channels 77. In this case, Fig. 11 illustrates the wafer stack resulting from applying a first processing step to spacer wafer stack 200 of Fig. 10, and Fig. 12 illustrates the wafer stack 100 resulting from applying a second processing step to spacer wafer stack 200 of Fig. 11. The two successively applied processing steps can be different processing steps, e.g., if both processing steps are carried out by means of milling, in the first processing step, a different milling tool may be used and possibly also a faster feed rate than in the second processing step may be applied. And it is also possible to combine different processing techniques in the processing steps, e.g., laser ablation first, and milling thereafter, or vice versa.

The second processing step may in particular be a fine-tuning step (for optimizing the compensation effect).

And even further, Figs. 11 and 12 may be looked upon as illustrating a possible way of proceeding in case of multi-channel devices, such as four-channel devices with a 2 x 2 array of channels (cf. Figs. 11 and 12). As illustrated in Fig. 11, it is possible to carry out the first processing step individually for one device, i.e. for one spacer member, but carry out the second processing step individually for each light channel 77 (cf. Fig. 12).

Thus, after a separation step (cf. the thick dashed lines in Fig. 12), spacer members will usually be obtained which have different heights (vertical extensions) and thus different geometrical lengths gl, g2, g3 of their light channels, which, however, are equal for all light channels of one spacer member, but corrections for, e.g., focal lengths, can be made (in the second procesing step) individually for each channel.

In an embodiment like the one of Figs. 10 to 12, bonding of detection members to the spacer members will usually have to take place after separation of spacer wafer 200 which may be accomplished during separating wafer stack 100.

Fig. 13 illustrates a two-times processed spacer member comprising more than one unitary parts (SW1, ml, m2), in a cross-sectional view, according to a non claimed example. In fact, Fig. 13 very much corresponds to Fig. 12, but spacer wafer SW2 is horizontally (laterally) mirrored, and, in addition, the (laterally defined) area in which material is removed in the second processing step is reduced with respect to what is illustrated in Fig. 12.

In case of the example like illustrated in Fig. 13, data would be obtained on manufacturing irregularities of passive optical components 65, or, in particular, of sets of passive optical components composed of the passive optical components belonging to one and the same light channel. Based on such data, layer m2 of spacer wafer SW2 would be subjected to a first processing step (similar to what is illustrated in Fig. 11). This first processing step would in particular be applied simultaneously to all light channels of a spacer member (and typically using one and the same tool), but separately for different spacer members.

Thereafter, possibly based on further data on manufacturing irregularities of passive optical components 65 (possibly obtained from a preliminary assembly of optics wafer OW, spacer wafer SW1 and spacer wafer SW2), a second processing step is applied, in which each light channel is individually addressed.

Then, spacer wafers SW1 and SW2 and optics wafer OW are bonded together so as to form a wafer stack 100. This may be accomplished in one or more steps. It is also possible that a detection wafer comprising a multitude of detection members (cf. Fig. 1) is bonded to spacer wafer SW2 already at this point - or this is accomplished thereafter.

Finally, a separation step is applied in which separate devices are obtained, e.g., by dicing or laser cutting. A so-obtained device can be, e.g., a computational camera or a module for a computational camera, or an array camera or a module for an array camera.

Figs. 14 to 16 illustrate, in a cross-sectional view, a spacer member with non-transparently (laterally) encompassed light channels 77, according to a non claimed example. The example of Fig. 5 is similar thereto and, in fact, Figs. 14 to 16 allow to illustrate ways of obtaining a spacer wafer as illustrated in Fig. 5.

Fig. 14 illustrates a member of non-transparent material comprising through-holes as light channels, in a cross-sectional view; Fig. 15 illustrates, in a cross-sectional view, the member of Fig. 14, but with transparent material filled in the light channels; and Fig. 16 illustrates the member of Fig. 14, with dfferent amounts of transparent material filled in the light channels, in a cross-sectional view.

For obtaining a spacer member 70 like illustrated in Figs. 5 and 16, a wafer comprising a multitude of through-holes (cf. Fig. 14) may be provided. Such a wafer can be obtained, e.g., as a unitary part, e.g., using a replication process. Then, a liquid hardenable material is filled into the through holes and is thereafter hardened, e.g., cured. During this, said wafer can be placed on a substrate such as on a mat of a silicone in order to avoid liquid material flowing out of the through-holes. After hardening, the filled-in material is transparent. Possibly, a polishing step may be applied to the so-obtained wafer, in order to have a high-quality optical surface at the detector side.

In a first way of obtaining a spacer member 70 like illustrated in Figs. 5 and 16, the amount of liquid material filled in the holes is selected individually for each light channel, so as to accomplish the desired adjustment of optical path lengths. In a second way, the amount of material filled in is (at least nominally) equal for all through-holes (i.e. for all light channels) of a spacer member, wherein it can be (at least nominally) equal for all through-holes (i.e. for all light channels) of a spacer wafer (cf- Fig. 15).

After hardening, then, a processing step is carried out, for adding more of a (or of the same) liquid hardenable material individually for the light channels and/or for removing a portion of said liquid hardenable material individually for the light channels. Such a fine-tuning step, however, can also be applied in case of the before-addressed first way.

For filling-in liquid material, e.g., a dispenser (like known from electronics manufacturing for underfilling flip chips and the like) may be used. For removing material, machining or milling or drilling or laser ablation may be used.

As will have become clear from the above, the invention may allow to mass produce high-precision optical devices on wafer scale at a very high yield. In particular if replication is used during (or for) manufacturing optics wafers and/or optics members and/or passive optical components, in particular when a replication step is used for manufacturing simultaneously (or in a single process) a multitude of optics members and/or of passive optical components, repeatable manufacturing irrgularities may occur which can very well be compensated for by means of the invention. Therein, replication may or may not be applied for accomplishing said compensation, e.g., for producing a compensating spacer wafer or compensating spacer members.

## Claims

1. A method for manufacturing a device (50), said method comprising the steps of
-- providing a spacer wafer comprising M ≥ 2 spacer members (70), wherein M is an integer, each of said M spacer members (70) comprising N ≥ 2 light channels (77), N being an integer, and wherein a plurality of said M x N light channels (77) each comprise a blind hole (75) forming a portion of the respective light channel;
-- providing an optics wafer (OW) comprising M optics members (60), each of said M optics members (60) comprising N sets of passive optical components (65) comprising one or more passive optical components each;
-- providing a detection wafer comprising M detection members (80), each of said M detection members (80) comprising N active optical components (85);
-- forming a wafer stack (100) comprising said optics wafer (OW), said detection wafer and, arranged between said optics wafer (OW) and said detection wafer, said spacer wafer (SW2);
wherein each of said M spacer members (70) is associated with a different one of said optics members (60) and associated with a different one of said detection members (80), and
wherein for each of said M spacer members (70), each of the respective N light channels (77) is associated with a different one of the N sets of passive optical components (65) of the associated optics member (60) and associated with a different one of the N active optical components (85) of the associated detection members (80), and
wherein, for at least a first spacer member of said M spacer members (70) and the associated optics members (60) and the associated detection members (80),
-- all of the N light channels (77) of the first spacer member provide an identical geometrical path length for light travelling from the associated set of passive optical components (65) of the associated optics member (60) through the respective light channel (77) to the associated active optical component of the associated detection member (80), and
-- an optical path length for light travelling from a first of the N sets of passive optical components (65) of a respective optics member (60) through the associated light channel (77) of the first spacer member to the associated active optical component (85) is different from an optical path length for light travelling from a second of said N sets of passive optical components (65) through the respective associated light channel (77) of the first spacer member to the respective associated active optical component (85);
wherein for each of said M x N light channels (77), said optical path length has a value related to and/or is chosen in dependence of manufacturing irregularities of the passive optical components of the set of passive optical components (65) of the respective associated optics member (60), and
wherein the method comprises manufacturing said spacer wafer (SW2) using a replication step, wherein a replication master used in said replication step is designed for accomplishing said different optical path lengths of the light channels (77),
and wherein the spacer wafer (SW2) obtained by the replication step is subjected to a further processing step comprising increasing the precision of optical path lengths of light channels (77) of the spacer wafer (SW2) obtained by the further processing step,
**characterized in that**,
said further processing step comprises removing material from the spacer member, and wherein a length of one or more blind holes in said spacer wafer is increased by means of cutting and/or machining and/or drilling and/or laser ablating.

2. The method according to claim 1, comprising separating said wafer stack (100) into a multitude of modules, each comprising one of said spacer members (70), one of said optics members (60) and one of said detection members (80), in particular each comprising exactly one of said spacer members (70), exactly one of said optics members (60) and exactly one of said detection members (80).

3. The method according to claim 1, comprising measuring said manufacturing irregularities.

4. The method according to any preceding claim, wherein said spacer wafer (SW2) comprises a first layer (m1) and a second layer (m2) which are made of mutually different materials.

5. The method according to claim 4, wherein the method comprises adjusting said optical path by removing material from said second layer (m2), and optionally wherein said second layer (m2) is made of a polymer material.

6. The method according to any preceding claim, wherein said device is a camera or an opto-electronic module for a camera.

## Patentansprüche

1. Verfahren zum Herstellen einer Vorrichtung (50), wobei das Verfahren die folgenden Schritte umfasst:
- Bereitstellen eines Abstandshalterwafers, der M ≥ 2 Abstandshalterelemente (70) umfasst, wobei M eine ganze Zahl ist, wobei jedes der M Abstandshalterelemente (70) N ≥ 2 Lichtkanäle (77) umfasst, wobei N eine ganze Zahl ist, und wobei eine Vielzahl der M x N Lichtkanäle (77) jeweils ein Sackloch (75) umfasst, das einen Abschnitt des jeweiligen Lichtkanals bildet;
- Bereitstellen eines optischen Wafers (OW), der M optische Elemente (60) umfasst, wobei jedes der M optischen Elemente (60) N Sätze von passiven optischen Komponenten (65) umfasst, die jeweils eine oder mehrere passive optische Komponenten umfassen;
- Bereitstellen eines Detektionswafers, der M Detektionselemente (80) umfasst, wobei jedes der M Detektionselemente (80) N aktive optische Komponenten (85) umfasst;
- Bilden eines Waferstapels (100), umfassend den optischen Wafer (OW), den Detektionswafer und, zwischen dem optischen Wafer (OW) und dem Detektionswafer angeordnet, den Abstandshalterwafer (SW2);
wobei jedes der M Abstandshalterelemente (70) einem anderen der optischen Elemente (60) und einem anderen der Detektionselemente (80) zugeordnet ist, und
wobei für jedes der M Abstandshalterelemente (70) jeder der jeweiligen N Lichtkanäle (77) einem anderen der N Sätze von passiven optischen Komponenten (65) des zugeordneten optischen Elements (60) und einer anderen der N aktiven optischen Komponenten (85) der zugeordneten Detektionselemente (80) zugeordnet ist, und
wobei für mindestens ein erstes Abstandshalterelement der M Abstandshalterelemente (70) und der zugeordneten optischen Elemente (60) und der zugeordneten Detektionselemente (80),
- alle der N Lichtkanäle (77) des ersten Abstandshalterelements eine identische geometrische Weglänge für Licht bereitstellen, das sich von dem zugeordneten Satz passiver optischer Komponenten (65) des zugeordneten optischen Elements (60) durch den jeweiligen Lichtkanal (77) zu der zugeordneten aktiven optischen Komponente des zugeordneten Detektionselements (80) bewegt, und
- eine optische Weglänge für Licht, das sich von einem ersten der N Sätze von passiven optischen Komponenten (65) eines jeweiligen optischen Elements (60) durch den zugeordneten Lichtkanal (77) des ersten Abstandshalterelements zu der zugeordneten aktiven optischen Komponente (85) bewegt, sich von einer optischen Weglänge für Licht unterscheidet, das sich von einem zweiten der N Sätze von passiven optischen Komponenten (65) durch den jeweiligen zugeordneten Lichtkanal (77) des ersten Abstandshalterelements zu der jeweiligen zugeordneten aktiven optischen Komponente (85) bewegt;
wobei für jeden der M x N Lichtkanäle (77) die optische Weglänge einen Wert aufweist, der sich auf Herstellungsunregelmäßigkeiten der passiven optischen Komponenten des Satzes passiver optischer Komponenten (65) des jeweiligen zugeordneten optischen Elements (60) bezieht und/oder in Abhängigkeit von diesen gewählt wird, und
wobei das Verfahren das Herstellen des Abstandshalterwafers (SW2) unter Verwendung eines Replikationsschritts umfasst, wobei ein Replikationsmaster, der in dem Replikationsschritt verwendet wird, zum Erzielen der unterschiedlichen optischen Weglängen der Lichtkanäle (77) ausgelegt ist,
und wobei der durch den Replikationsschritt erhaltene Abstandshalterwafer (SW2) einem weiteren Verarbeitungsschritt unterzogen wird, der das Erhöhen der Genauigkeit von optischen Weglängen von Lichtkanälen (77) des durch den weiteren Verarbeitungsschritt erhaltenen Abstandshalterwafers (SW2) umfasst,
**dadurch gekennzeichnet, dass**
der weitere Verarbeitungsschritt das Entfernen von Material von dem Abstandshalterelement umfasst, und wobei eine Länge von einem oder mehreren Sacklöchern in dem Abstandshalterwafer durch Schneiden und/oder Bearbeiten und/oder Bohren und/oder Laserabtragen vergrößert wird.

2. Verfahren nach Anspruch 1, umfassend das Trennen des Waferstapels (100) in eine Vielzahl von Modulen, die jeweils eines der Abstandshalterelemente (70), eines der optischen Elemente (60) und eines der Detektionselemente (80) umfassen, wobei insbesondere jedes genau eines der Abstandshalterelemente (70), genau eines der optischen Elemente (60) und genau eines der Detektionselemente (80) umfasst.

3. Verfahren nach Anspruch 1, umfassend das Messen der Herstellungsunregelmäßigkeiten.

4. Verfahren nach einem vorhergehenden Anspruch, wobei der Abstandshalterwafer (SW2) eine erste Schicht (m1) und eine zweite Schicht (m2) umfasst, die aus wechselseitig unterschiedlichen Materialien hergestellt sind.

5. Verfahren nach Anspruch 4, wobei das Verfahren das Einstellen des optischen Weges durch Entfernen von Material von der zweiten Schicht (m2) umfasst, und wobei wahlweise die zweite Schicht (m2) aus einem Polymermaterial hergestellt ist.

6. Verfahren nach einem vorhergehenden Anspruch, wobei die Vorrichtung eine Kamera oder ein optoelektronisches Modul für eine Kamera ist.

## Revendications

1. Procédé de fabrication d'un dispositif (50), ledit procédé comprenant les étapes consistant à
- fournir une plaquette d'écartement comprenant M ≥ 2 éléments d'écartement (70), dans lequel M est un nombre entier, chacun desdits M éléments d'écartement (70) comprenant N ≥ 2 canaux lumineux (77), N étant un nombre entier, et dans lequel une pluralité desdits M x N canaux de lumière (77) comprennent chacun un trou borgne (75) formant une partie du canal de lumière respectif ;
- fournir une plaquette optique (OW) comprenant M éléments optiques (60), chacun desdits M éléments optiques (60) comprenant N ensembles de composants optiques passifs (65) comprenant chacun un ou plusieurs composants optiques passifs ;
- fournir une plaquette de détection comprenant M éléments de détection (80), chacun desdits M éléments de détection (80) comprenant N composants optiques actifs (85);
- former un empilement de plaquettes (100) comprenant ladite plaquette optique (OW), ladite plaquette de détection et, disposée entre ladite plaquette optique (OW) et ladite plaquette de détection, ladite plaquette d'écartement (SW2) ;
dans lequel chacun desdits M éléments d'écartement (70) est associé à un élément différent desdits éléments optiques (60) et associé à un élément différent desdits éléments de détection (80), et
dans lequel pour chacun desdits M éléments d'écartement (70), chacun des N canaux de lumière respectifs (77) est associé à un ensemble différent des N ensembles de composants optiques passifs (65) de l'élément optique associé (60) et associé à un un composant différent des N composants optiques actifs (85) des éléments de détection associés (80), et
dans lequel, pour au moins un premier élément d'écartement parmi lesdits M éléments d'écartement (70) et les éléments optiques associés (60) et les éléments de détection associés (80),
- tous les N canaux de lumière (77) du premier élément d'écartement fournissent une longueur de chemin géométrique identique pour la lumière voyageant depuis l'ensemble associé de composants optiques passifs (65) de l'élément optique associé (60) à travers le canal de lumière respectif (77) vers le composant optique actif associé de l'élément de détection associé (80), et
- une longueur de chemin optique pour la lumière voyageant depuis un premier des N ensembles de composants optiques passifs (65) d'un élément optique respectif (60) à travers le canal de lumière associé (77) du premier élément d'écartement vers le composant optique actif associé (85) est différente d'une longueur de chemin optique pour la lumière voyageant depuis un deuxième desdits N ensembles de composants optiques passifs (65) à travers le canal de lumière associé respectif (77) du premier élément d'écartement vers le composant optique actif associé respectif (85) ;
dans lequel pour chacun desdits M x N canaux de lumière (77), ladite longueur de chemin optique a une valeur liée à et/ou est choisie en fonction des irrégularités de fabrication des composants optiques passifs de l'ensemble de composants optiques passifs (65) de l'élément optique associé respectif (60), et
dans lequel le procédé comprend la fabrication de ladite plaquette d'écartement (SW2) en utilisant une étape de réplication, dans lequel un maître de réplication utilisé dans ladite étape de réplication est conçu pour accomplir lesdites différentes longueurs de chemin optique des canaux de lumière (77),
et dans lequel la plaquette d'écartement (SW2) obtenue par l'étape de réplication est soumise à une étape de traitement supplémentaire comprenant l'augmentation de la précision des longueurs de chemin optique des canaux lumineux (77) de la plaquette d'écartement (SW2) obtenue par l'étape de traitement supplémentaire,
**caractérisé en ce que**
ladite étape de traitement supplémentaire comprend l'enlèvement de matériau de l'élément d'écartement, et dans lequel une longueur d'un ou de plusieurs trous borgnes dans ladite plaquette d'écartement est augmentée au moyen d'une découpe et/ou d'un usinage et/ou d'un forage et/ou d'une ablation au laser.

2. Procédé selon la revendication 1, comprenant la séparation dudit empilement de plaquettes (100) en une multitude de modules comprenant chacun un desdits éléments d'écartement (70), un desdits éléments optiques (60) et un desdits éléments de détection (80), en particulier chacun comprenant exactement un desdits éléments d'écartement (70), exactement un desdits éléments optiques (60) et exactement un desdits éléments de détection (80).

3. Procédé selon la revendication 1, comprenant la mesure desdites irrégularités de fabrication.

4. Procédé selon une quelconque revendication précédente, dans lequel ladite plaquette d'écartement (SW2) comprend une première couche (m1) et une deuxième couche (m2) qui sont constituées de matériaux mutuellement différents.

5. Procédé selon la revendication 4, dans lequel le procédé comprend l'ajustement dudit chemin optique en enlevant du matériau de ladite deuxième couche (m2), et optionnellement dans lequel ladite deuxième couche (m2) est constituée d'un matériau polymère.

6. Procédé selon une quelconque revendication précédente, dans lequel ledit dispositif est une caméra ou un module optoélectronique pour une caméra.
